Europäisches Patentamt

European Patent Office

Office européen des brevets

(11) Numéro de publication: **0 342 101**

**A1**

## (12) DEMANDE DE BREVET EUROPEEN

(21) Numéro de dépôt: **89401252.5**

(22) Date de dépôt: **03.05.89**

(51) Int. Cl.⁴: **G 01 R 1/36**
**H 02 H 3/04**

(30) Priorité: **11.05.88 FR 8806357**

(43) Date de publication de la demande:
**15.11.89 Bulletin 89/46**

(84) Etats contractants désignés:
**AT BE CH DE ES GB IT LI LU NL SE**

(71) Demandeur: **CHAUVIN-ARNOUX, Société en commandite par actions**
**190, rue Championnet**
**F-75890 Paris Cédex 18 (FR)**

(72) Inventeur: **Arnoux, Daniel**
**190 Rue Championnet**
**F-75018 Paris (FR)**

**Arnoux, Axel**
**190 Rue Championnet**
**F-75018 Paris (FR)**

**Genter, Claude**
**190 Rue Championnet**
**F-75018 Paris (FR)**

**Piaud, Didier**
**190 Rue Championnet**
**F-75018 Paris (FR)**

(74) Mandataire: **Lefebure, Gérard et al**
**Office Blétry 2, boulevard de Strasbourg**
**F-75010 Paris (FR)**

(54) **Dispositif testeur de fusible pour appareil de mesure d'intensité de courant.**

(57) Dans cet appareil de mesure comprenant une première et une seconde borne d'entrée (1 et 2), un fusible (4) et une résistance shunt (3) connectés en série entre les bornes d'entrée, et un circuit de mesure (5) connecté aux bornes de la résistance shunt, la première borne d'entrée (1) est connectée à un point (7) de potentiel fixe (V) par l'intermédiaire d'une résistance (8) ayant une valeur ohmique ($R_1$) élevée par rapport à celle ($r_0$) de la résistance shunt (3), et les deux bornes d'entrée (1 et 2) sont reliées à un circuit à seuil (12) produisant sur sa sortie un signal ayant un premier état quand le fusible (4) est en bon état, et un second état quand le fusible est coupé. Un circuit d'alarme (13) est activé par le signal de sortie du circuit à seuil (12) quand le fusible (4) est coupé.

FIG.1

EP 0 342 101 A1

**Description**

## Dispositif testeur de fusible pour appareil de mesure d'intensité de courant.

La présente invention concerne un appareil de mesure d'intensité de courant comprenant une première et une seconde borne d'entrée, un fusible et une résistance shunt connectées en série entre lesdites bornes d'entrée, et un circuit de mesure connecté aux bornes de la résistance shunt.

Dans les appareils de mesure de courant et, en particulier dans les multimètres, des moyens sont généralement prévus pour protéger l'appareil en cas de valeur excessive du courant. Une telle situation peut par exemple se produire en cas d'erreur de branchement de l'appareil, par exemple lorsque l'utilisateur effectue une mesure de tension alors que le sélecteur de fonction de l'appareil est resté dans une position correspondant à une mesure d'intensité. Ce moyen de protection est, dans de nombreux cas, constitué par un fusible en série avec la résistance shunt parcourue par le courant à mesurer.

Le problème se pose alors à l'utilisateur de savoir, avant d'utiliser l'appareil de mesure, si le fusible est en bon état.

Une solution pour résoudre ce problème peut consister à utiliser si elle existe, la fonction ohmmètre de l'appareil de mesure. Non seulement cette solution n'est pas toujours possible, mais même lorsque l'appareil est équipé d'une fonction ohmmètre, cette solution nécessite que l'utilisateur effectue des commutations, et elle entraîne des risques de fausses manoeuvres en cours de mesure, qui peuvent être dangereuses tant pour l'appareil de mesure que pour l'utilisateur.

La présente invention a donc pour but d'informer l'utilisateur d'un appareil de mesure de courant de l'état du fusible de l'appareil, dès la mise en marche de celui-ci, sans que l'utilisateur ait à effectuer d'autres manoeuvres que celles du bouton de marche/arrêt de l'appareil de mesure.

A cet effet, l'appareil de mesure de la présente invention est caractérisé en ce que la première borne d'entrée est connectée à un point de potentiel fixe par l'intermédiaire d'une résistance ayant une valeur ohmique élevée par rapport à celle de la résistance shunt, et en ce que les deux bornes d'entrée sont reliées à un circuit à seuil produisant sur sa sortie un signal ayant un premier état quand le fusible est en bon état, et un second état quand le fusible est coupé.

Le point de potentiel fixe peut être par exemple un point qui est au potentiel d'alimentation de l'appareil de mesure quand l'interrupteur de marche/arrêt de celui-ci se trouve dans la position marche. Ainsi, dès que l'appareil de mesure est mis en marche, le circuit à seuil fournit sur sa sortie un signal qui est représentatif du bon ou du mauvais état du fusible de l'appareil de mesure. Ce dernier peut alors comporter un moyen d'alarme visuel et/ou sonore, qui est activé en réponse au second état du signal de sortie du circuit à seuil.

Dans le cas où l'appareil de mesure comporte un afficheur, par exemple un afficheur à cristaux liquides, ce dernier peut comporter une zone d'affichage qui, lorsqu'elle est activée, indique une condition d'erreur ou d'alarme. Dans ce cas, l'afficheur peut être connecté à la sortie du circuit à seuil, de telle façon que ladite zone d'affichage soit activée en réponse au second état du signal de sortie du circuit à seuil.

L'invention sera maintenant décrite en faisant référence aux dessins annexés sur lesquels :

la figure 1 est un schéma, en partie par blocs, montrant un appareil de mesure de courant conforme à la présente invention.

La figure 2 montre une variante de l'appareil de la figure 1.

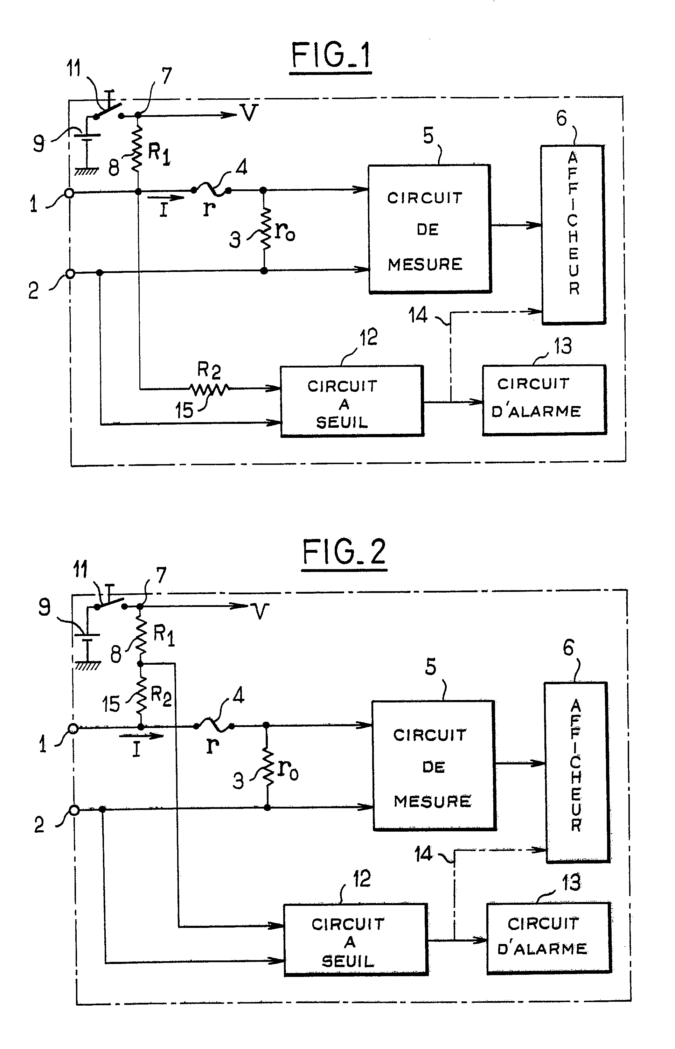

L'appareil de mesure de courant représenté sur la figure 1 comprend deux bornes d'entrée 1 et 2, la borne 1 correspondant au point chaud de la mesure. La borne 1 est reliée à l'une des extrémités du shunt 3 de l'appareil de mesure par l'intermédiaire d'un fusible 4, l'autre extrémité du shunt 3 étant reliée à la borne d'entrée 2.

En service, la tension qui apparaît aux bornes du shunt 3 et qui est proportionnelle au courant I à mesurer, est mesurée de façon classique par un circuit de mesure 5 et la valeur du courant I à mesurer est indiquée de façon classique par un dispositif indicateur 6, qui peut être de n'importe quel type connu (indicateur à cadran et à aiguille, afficheur numérique et/ou analogique quantifié à électrodes électroluminescentes ou à cristaux liquides, etc).

Selon l'invention, la borne 1 est en outre reliée à un point 7 de potentiel fixe V par l'intermédiaire d'une résistance 8 de forte valeur. Le point 7 peut être un point qui est au potentiel de la source d'alimentation 9 de l'appareil de mesure quand l'interrupteur de marche/arrêt 11 de ce dernier est fermé.

Ainsi, quand l'interrupteur 11 est fermé et avant même que les bornes d'entrée 1 et 2 de l'appareil de mesure soient connectées à un circuit parcouru par un courant à mesurer, il apparait sur la borne d'entrée 1 une tension qui peut prendre l'une ou l'autre de deux valeurs selon l'état du fusible 4. Plus précisément, si le fusible 4 est en bon état, il apparaît sur la borne d'entrée 1 une tension $V(r+r_0)/(R_1+r+r_0)$, où V est le potentiel fixe au point 7 et $r_0$, r et $R_1$ sont respectivement les valeurs ohmiques du shunt 3, du fusible 4 et de la résistance 8. Par contre, si le fusible 4 est coupé, il apparaît sur la borne 1 une tension égale au potentiel V.

On notera que, lorsque le fusible 4 est en bon état, il apparaît aux bornes du shunt 3 une tension parasite $V.r_0/(R_1+r+r_0)$. La valeur $R_1$ de la résistance 8 doit dont être choisie de telle sorte que, lorsque l'appareil de mesure est en service cette tension parasite reste négligeable par rapport à la tension $r_0 I$ engendrée par le courant à mesurer. Autrement dit, $R_1$ doit être grand par rapport à $r_0$. La valeur $R_1$ de la résistance 8 doit être en outre choisie de telle façon que si, en service, la borne d'entrée 1 est elle-même à un potentiel relativement élevé par suite du branchement de l'appareil de mesure dans un circuit parcouru par un courant à mesurer, et si le fusible 4 fond par suite d'un courant trop important, le courant qui est alors dérivé vers la source d'alimentation 9 à travers la résistance 8 soit le plus faible possible. C'est pourquoi, bien que, du strict point de vue de la précision de la mesure, il suffirait que $R_1$ soit 100 ou 1000 fois plus grand que $r_0$, en pratique on choisira une résistance $R_1$ encore plus grande.

A titre d'exemple, pour une tension d'alimentation V de 9 volts, si $r_0$ est égal à 10 m$\Omega$ pour un calibre de mesure de 10A, on choisira pour $R_1$ une valeur au moins égale 10$^4\Omega$. Dans ces conditions, en supposant que la résistance r du fusible 4 est du même ordre de grandeur que $r_0$, soit 10 m$\Omega$, la tension parasite aux bornes du shunt 3 est alors au plus égale à $9.10^{-6}$ volts, ce qui est parfaitement négligeable. En outre, en supposant que la borne d'entrée 1 se trouve à un potentiel relativement élevé, par exemple 380V, quand l'appareil de mesure est branché dans un circuit parcouru par un courant à mesurer, le courant qui serait dérivé vers la source d'alimentation 9 à travers la résistance 8 en cas de rupture du fusible 4 serait alors au plus égal à 38mA.

Pour indiquer l'état du fusible 4, la tension entre les bornes 1 et 2 est appliquée à un circuit à seuil 12 qui peut être de n'importe quel type connu. Le circuit à seuil peut être par exemple constitué par une bascule de Schmidt ou encore, si l'appareil de mesure inclut un microprocesseur, il peut être alors avantageusement constitué par un port d'entrée du microprocesseur. Dans ce dernier cas, le microprocesseur peut être programmé pour effectuer un autotest de l'appareil de mesure dès la mise en marche de ce dernier, pour vérifier entre autres choses le bon état du fusible 4.

Avec les valeurs indiquées plus haut du potentiel fixe V et des résistances $r_0$, r et $R_1$, la tension entre les bornes 1 et 2, donc la tension appliquée à l'entrée du circuit à seuil 12 est au plus égale à $9.10^{-6}$ volts, donc quasiment nulle, quand le fusible 4 est en bon état, et elle est égale à 9 volts quand le fusible 4 est coupé. Dans l'exemple considéré ici, le circuit à seuil devra donc avoir un seuil de basculement dont la valeur est comprise entre les deux valeurs de tension susindiquées. Il est donc tout-à-fait clair que de nombreux types de circuit à seuil peuvent convenir ici. En fait, tout ce que l'on demande au circuit à seuil 12 c'est de produire sur sa sortie un signal ayant un premier état quand la tension entre les bornes 1 et 2 a une valeur relativement faible (plus petite que le seuil de basculement du circuit à seuil 12) indiquant que la fusible 4 est en bon état, et un second état quand la tension entre les bornes 1 et 2 a une valeur relativement grande (plus grande que ledit seuil de basculement) indiquant que le fusible 4 est coupé. Le signal de sortie à deux états du circuit à seuil 12 peut être utilisé pour commander un circuit d'alarme 13 incluant une alarme sonore et/ou lumineuse, de telle façon que ladite alarme soit activée quand le signal de sortie du circuit à seuil 12 est dans son second état. Le moyen d'alarme inclus dans le circuit 13 peut être par exemple une diode électroluminescente, un vibreur, un générateur de bips sonores, etc.

Quand le dispositif indicateur 6 de l'appareil de mesure est constitué par un afficheur tel qu'un afficheur à cristaux liquides, l'afficheur peut comporter une zone spéciale d'affichage qui, lorsqu'elle est activée, indique une condition d'erreur ou d'alarme sous la forme d'un symbole ou d'un message visible approprié. Dans ce cas, comme cela est indiqué par la liaison 14 en traits mixtes dans la figure 1, le signal de sortie du circuit à seuil 12 peut être aussi utilisé pour commander ladite zone spéciale d'affichage de manière à "allumer" le symbole ou message d'erreur ou d'alarme quand le signal de sortie du circuit à seuil 12 est dans son second état. Par exemple, il est possible de faire en sorte qu'en cas de rupture ou de fusion du fusible 4, il soit produit à la fois un signal sonore par le circuit d'alarme 13 et l'affichage d'un symbole ou d'un message d'erreur par la zone spéciale d'affichage de l'afficheur 6.

D'après ce qui précède, il est clair que la présente invention fournit un appareil de mesure de courant avec lequel l'utilisateur est, le cas échéant, aussitôt informé de l'état coupé ou fondu du fusible 4 dès que l'interrupteur de marche/arrêt est fermé.

Un problème peut toutefois apparaître en cas de branchement de l'appareil de mesure lorsque le fusible est coupé ou en cas de fusion du fusible en cours de mesure. En effet, dans ce cas, la tension de la source engendrant le courant à mesurer se trouve alors appliquée au circuit à seuil 12 et peut entraîner sa destruction. Pour éviter cela, la borne d'entrée 1 n'est pas reliée directement au circuit à seuil 12, mais par l'intermédiaire d'une résistance 15 comme cela est montré dans la figure 1. La valeur ohmique $R_2$ de la résistance 15 est choisie de façon à limiter le courant vers le circuit à seuil 12 en cas de rupture ou de fusion du fusible 4 en cours de mesure. $R_2$ peut avoir par exemple une valeur de l'ordre de $10^4$ à $10^5\Omega$ ou plus.

Dans la variante d'exécution représentée sur la figure 2, la borne d'entrée 1 est reliée au point 7 de potentiel fixe par l'intermédiaire des deux résistances 15 et 8 connectées en série, et le point de jonction entre les deux résistances 15 et 8 est connecté à l'entrée du circuit à seuil 12. Là encore, la valeur ohmique $R_2$ de la résistance 15 est choisie pour limiter la valeur du courant vers le circuit à seuil 12 en cas de rupture ou de fusion du fusible 4. Toutefois, dans ce cas, $R_2$ doit être également choisie de telle façon que les valeurs de la tension appliquée à l'entrée du circuit à seuil 12 respectivement quand le fusible 4 est en bon état et quand il est coupé soient suffisamment différentes l'une de l'autre pour pourvoir être facilement distinguées l'une de l'autre par ledit circuit à seuil. Naturellement, dans ce cas encore, la somme de $R_1$ et $R_2$ doit avoir une valeur nettement plus élevée que la résistance $r_0$ du shunt 3, pour les mêmes raisons que celles qui ont déjà été exposées plus haut à propos de la résistance $R_1$ de la figure 1.

A titre d'exemple, dans le cas de la figure 2, si le potentiel V est encore égal à 9 volts et si $R_1$ et $R_2$ ont la même valeur, par exemple 47k$\Omega$, une tension d'environ 4,5 volts sera appliquée à l'entrée du circuit à seuil 12 quand le fusible 4 est en bon état, tandis que la tension appliquée à l'entrée du circuit à seuil 12 sera de 9 volts quand le fusible 4 est coupé.

Il va de soi que les formes d'exécution de la présente invention qui ont été décrites ci-dessus ont été données à titre d'exemple purement indicatif et nullement limitatif, et que de nombreuses modifications peuvent être facilement apportées par l'homme de l'art sans pour autant sortir du cadre de la présente invention.

**Revendications**

1.- Appareil de mesure d'intensité de courant comprenant une première et une seconde borne d'entrée (1 et 2), un fusible (4) et une résistance shunt (3) connectés en série entre lesdites bornes d'entrée, et un circuit de mesure (5) connecté aux bornes de la résistance shunt, caractérisé en ce que la première borne d'entrée (1) est connectée à un point (7) de potentiel fixe (V) par l'intermédiaire d'une résistance (8) ayant une valeur ohmique ($R_1$) élevée par rapport à celle ($r_0$) de la résistance shunt (3), et en ce que les deux bornes d'entrée (1 et 2) sont reliées à un circuit à seuil (12) produisant sur sa sortie un signal ayant un premier état quand le fusible (4) est en bon état, et un second état quand le fusible est coupé.

2.- Appareil selon la revendication 1, caractérisé en ce que la première borne d'entrée (1) est reliée au circuit à seuil (12) par l'intermédiaire d'une résistance (15) de limitation de courant.

3.- Appareil selon la revendication 2, caractérisé en ce que ladite résistance de valeur ohmique élevée est composée de deux résistances (8 et 15) connectées en série entre la première borne d'entrée (1) et la point (7) de potentiel fixe, et en ce que l'une (15) de ces deux résistances (8 et 15) constitue ladite résistance de limitation de courant.

4.- Appareil selon l'une quelconque des revendications 1 à 3, caractérisé en ce que le circuit à seuil (12) est constitué par une bascule de Schmidt.

5.- Appareil selon l'une quelconque des revendications 1 à 3, caractérisé en ce que le circuit à seuil (12) est constitué par un microprocesseur.

6.- Appareil selon l'une quelconque des revendications 1 à 5, caractérisé en ce qu'il comprend un moyen d'alarme (13), qui est activé en réponse au second état du signal de sortie du circuit à seuil (12).

7.- Appareil selon l'une quelconque des revendications 1 à 6, comprenant en outre un afficheur (6), caractérisé en ce que l'afficheur (6) comporte une zone d'affichage qui, lorsqu'elle est activée, indique une condition d'erreur ou d'alarme, et en ce que ladite zone d'affichage est activée en réponse au second état du signal de sortie du circuit à seuil (12).

## FIG_1

## FIG_2

**Office européen des brevets**

# RAPPORT DE RECHERCHE EUROPEENNE

Numero de la demande

EP 89 40 1252

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | DE-B-2 212 201 (GOSSEN) <br> * colonne 1, lignes 30-49 * <br> --- | 1 | G 01 R 1/36 <br> H 02 H 3/04 |
| A | FR-A-2 309 121 (R. PENHOUET) <br> * page 2, lignes 8-25; figure 1 * <br> --- | 1 | |
| A | E.D.N. ELECTRICAL DESIGN NEWS vol. 30, no. 11, mai 1985, page 232, Boston, Massachusetts, US; T.S. DORAISWAMY:"Circuit measures fuse's rupture current" * page 232 * <br> --- | 1 | |
| A | US-A-1 606 143 (J.T. BUTTERFIELD) <br> * page 2, lignes 3-27; figure 2 * <br> ----- | 1 | |

DOMAINES TECHNIQUES RECHERCHES (Int. Cl.4)

G 01 R 1/36
G 01 R 19/00
G 01 R 21/02
G 01 R 31/02
H 02 H 3/04

Le présent rapport a été établi pour toutes les revendications

| Lieu de la recherche | Date d'achèvement de la recherche | Examinateur |
|---|---|---|
| BERLIN | 27-07-1989 | LEMMERICH J |

EPO FORM 1503 03.82 (P0402)